# EUROPÄISCHE PATENTSCHRIFT

(11) **EP 0 927 358 B1**
(45) Veröffentlichungstag und Bekanntmachung des Hinweises auf die Patenterteilung: **23.01.2002**
(21) Anmeldenummer: 97938729.7
(22) Anmeldetag: 16.09.1997
(51) Int. Cl.: G01R 31/14, H03K 3/537

(54) **IMPULSSPANNUNGSGENERATORSCHALTUNG**
IMPULSE VOLTAGE GENERATOR CIRCUIT
CIRCUIT GENERATEUR DE TENSION DE CHOC

(30) Priorität: 23.09.1996 DE 19639023
(43) Veröffentlichungstag der Anmeldung: 07.07.1999
(73) Patentinhaber: Haefely Test AG, 4052 Basel (CH)
(72) Erfinder: WOLF, Jürgen, D-79576 Weil am Rhein (DE)
(74) Vertreter: Schalch, Rainer
(86) Internationale Anmeldenummer: CH9700341
(87) Internationale Veröffentlichungsnummer: WO9813701

(56) Entgegenhaltungen:
- CH-A- 238 586
- CH-A- 376 999
- CH-A- 547 572
- DE-A- 1 938 022
- DE-A- 2 446 387
- GB-A- 789 348

## Beschreibung

Die vorliegende Erfindung bezieht sich auf eine Impulsspannungsgeneratorschaltung zum Erzeugen von Blitzimpulsspannung zum Prüfen der Kapazität eines Prüflings, wie sie im Oberbegriff des unabhängigen Patentanspruchs 1 definiert ist.

Zur Prüfung von Objekten, die elektrisch eine Kapazität darstellen, werden in grossem Ausmass Impulsspannungsgeneratoren eingesetzt. Die verwendeten Impulsspannungsgeneratoren sind im allgemeinen in der seit 1924 bekannten Marx'schen Vervielfachungsschaltung mit mehreren aufladbaren Stufen aufgebaut, bei der jede Stufe in Serie geschaltet eine Stosskapazität und ein Schaltorgan, insbesondere eine Schaltfunkenstrecke, zu der Stosskapazität und dem Schaltorgan parallelgeschaltet einen Parallelwiderstand sowie hierzu in Serie geschaltet einen Seriewiderstand aufweist und zwei Stufen so miteinander verbunden sind, dass sie parallelgeschaltet aufladbar und in Serie geschaltet entladbar sind.

Beim Prüfen der Kapazität eines Prüflings werden an die letzte Stufe der Impulsspannungsgeneratorschaltung im allgemeinen der Prüfling selbst sowie ein kapazitiver Impulsspannungsteiler angeschlossen, der die beim Entladen der Stufen erzeugte Blitzimpulsspannung auf Werte reduziert, die von den Mess- und Aufzeichnungsgeräten verarbeitet werden können. Die Kapazitäten des Prüflings und des Impulsspannungsteilers sowie die vorhandenen Streukapazitäten bilden zusammen die Belastungskapazität der aus dem Impulsspannungsgenerator, Impulsspannungsteiler, Prüfling und den Verbindungsleitungen bestehenden Prüfschaltung, die ausserdem aufgrund der räumlichen Ausdehnung der gesamten Prüfanordnung eine unvermeidliche Induktivität aufweist. Die Belastungskapazität bildet zusammen mit dieser Induktivität einen Schwingkreis, der durch die Seriewiderstände der verschiedenen aufladbaren Stufen, die auch als Stirn-, Front-oder Dämpfungswiderstände bezeichnet werden, gedämpft wird. Die Seriewiderstände dienen zusätzlich zur Dämpfung, auch noch zum Einstellen der Stirnzeit der zu erzeugenden Spannungsimpulse. Um eine gewünschte Stirnzeit zu erreichen, müssen die Seriewiderstände desto kleiner gewählt werden, je grösser die Belastungskapazität ist.

Die Impulsspannungsgeneratoren werden üblicherweise dazu eingesetzt, Normblitzimpulsspannung 1,2/50 gemäss IEC 60-1 (1989) zu erzeugen, d.h. Spannungsimpulse mit einer Stirnzeit von 1,2 µs ± 30% und einer Rückenhalbwertszeit von 50 µs ± 20%. Um die vorgegebene Stirnzeit einzuhalten, müssen die Seriewiderstände bei grossen Belastungskapazitäten so klein gewählt werden, dass die erzeugte Blitzimpulsspannung gedämpft schwingt. Die Norm IEC 60-1 lässt ein Überschwingen von maximal 5% gegenüber dem nicht oszillierenden Spannungsverlauf zu. Daraus folgt, dass die theoretisch maximale Belastungskapazität, im folgenden als Grenzbelastungskapazität bezeichnet, eines Impulsspannungsgenerators sich ergibt, wenn die Seriewiderstände das Überschwingen gerade auf 5% begrenzen und die Stirnzeit die obere Toleranzgrenze von 1,56 µs erreicht. Eine Vergrösserung der Seriewiderstände würde das Überschwingen verringern, aber gleichzeitig die Stirnzeit vergrössern, während eine Verkleinerung der Seriewiderstände die Stirnzeit verkürzen, aber das Überschwingen vergrössern würde.

Eine Erhöhung der Grenzbelastungskapazität der Marx'schen Vervielfachungsschaltung ist bisher immer auf dem Weg versucht worden, den Impulsspannungsgenerator durch geeignete Anordnung der aufladbaren Stufen so induktivitätsarm wie möglich zu konstruieren. Bekannt sind beispielsweise eine mäanderartige Anordnung der aufladbaren Stufen, eine Aufteilung des Stromes im Generator in zwei gegenläufige Stromwege oder eine räumlich sehr enge Anordnung aller Bauteile. Bei konventioneller offener Bauweise kann ein induktivitätsarmer Aufbau des Impulsspannungsgenerators jedoch nur einen Teil der gesamten Induktivität beeinflussen, da die Grösse der äusseren Schleife, bestehend aus Prüfling und Verbindungsleitung, durch die zur Spannungsbeherrschung notwendigen Abstände und die geometrische Grösse des Prüflings bestimmt ist. Verbesserungen sind hier nur noch in geringem Masse möglich.

Auf der Anwenderseite besteht aber der Bedarf nach Grenzbelastungskapazitäten, die höher sind als die der bekannten Marx'schen Vervielfachungsschaltungen, z.B. bei der Prüfung von SF₆-isolierten Anlageteilen. Auch bei der Transformatorenprüfung wird der Impulsspannungsgenerator häufig mit Wicklungskapazitäten belastet, die keine normgerechte Stirnzeit mehr zulassen.

In der CH-A-376 999 ist eine Impulsspannungsgeneratorschaltung mit mehreren aufladbaren Stufen sowie ein Schaltungszusatz für eine solche Impulsspannungsgeneratorschaltung beschrieben. Bei dieser Impulsspannungsgeneratorschaltung werden durch zusätzlich eingebaute Kapazitäten Überspannungen, die während des Durchzündens des Impulsspannungsgenerators im Innern des Impulsspannungsgenerators auftreten, reduziert. Das Überschwingen der Impulsstirnen der Blitzimpulsspannung an der Belastungskapazität kann allein durch diese zusätzlichen Kapazitäten nicht verringert werden. Ausgehend von dieser Impulsspannungsgeneratorschaltung ist der jeweilige Oberbegriff des unabhängigen Patentanspruchs 1 und 9 gebildet worden.

Aus der CH-A-238 586 ist eine Impulsspannungsgeneratorschaltung bekannt, die eine einzige aufladbare Stufe mit Stosskapazität und Schaltfunkenstrecke aufweist, die mit einem Schaltungszusatz versehen ist, der in Serie geschaltet eine Funkenstrecke, einen Widerstand und eine Kapazität enthält. Dieser Schaltungszusatz dient zur Verkürzung der Stirnzeit der erzeugten Impulsspannung und eignet sich nicht zur Verringerung des Überschwingens der Impulsstirnen einer Blitzimpulsspannung an der Belastungskapazität.

Der Erfindung liegt daher die Aufgabe zugrunde, eine Impulsspannungsgeneratorschaltung der eingangs erwähnten Art zu schaffen, mit der eine höhere Grenzbelastungskapazität erreichbar ist als mit vergleichbaren bekannten Schaltungen.

Diese Aufgabe wird durch die erfindungsgemässe Impulsspannungsgeneratorschaltung gelöst, wie sie im unabhängigen Patentanspruch 1 definiert ist. Im unabhängigen Patentanspruch 9 ist ein erfindungsgemässer Schaltungszusatz definiert, mit dem die Grenzbelastungskapazität einer Impulsspannungsgeneratorschaltung der eingangs erwähnten Art vergrösserbar ist. Bevorzugte Ausführungsvarianten ergeben sich aus den abhängigen Patentansprüchen.

Das Wesen der Erfindung besteht darin, dass eine Impulsspannungsgeneratorschaltung zum Erzeugen von Blitzimpulsspannung zum Prüfen der Kapazität eines Prüflings, mit einer einzigen oder mehreren aufladbaren Stufen, wobei an die einzige bzw. die letzte Stufe eine die Prüflingskapazität mitumfassende Belastungskapazität anschliessbar ist, mit einem Schaltungszusatz zur Verringerung des Überschwingens der Impulsstirnen der Blitzimpulsspannung an der Belastungskapazität versehen ist, der eine Kompensationskapazität und dazu parallelgeschaltet zumindest einen Entladewiderstand oder eine Entladefunkenstrecke aufweist. Die bzw. jede aufladbare Stufe der Impulsspannungsgeneratorschaltung umfasst in Serie geschaltet eine Stosskapazität und ein Schaltorgan, zu der Stosskapazität und dem Schaltorgan parallelgeschaltet einen Parallelwiderstand sowie zu der Stosskapazität, dem Schaltorgan und dem Parallelwiderstand in Serie geschaltet einen Seriewiderstand, wobei zwei Stufen gegebenenfalls so miteinander verbunden sind, dass sie parallelgeschaltet aufladbar und in Serie geschaltet entladbar sind.

Der Schaltungszusatz reduziert nicht die Ursache des Überschwingens, sondern kompensiert das Überschwingen der Spannung an der Belastungskapazität, d.h. insbesondere am Prüfling. Der Grundgedanke der Erfindung besteht darin, während des Überschwingens an der Belastungskapazität, eine Spannungsverringerung zu erreichen, die nach Abklingen des Überschwingens aufgehoben wird. Das Überschwingen wird nicht allgemein reduziert, sondern so kompensiert, dass am Prüfling keine Spannungsüberhöhung auftritt.

Aufgrund der Verringerung des Überschwingens der Impulsstirnen der Blitzimpulsspannung bei der Belastungskapazität ist die Grenzbelastungskapazität bei der erfindungsgemässen Impulsspannungsgeneratorschaltung wesentlich höher als bei den bisher bekannten Schaltungen, d.h. es können wesentlich höhere Prüflingskapazitäten geprüft werden.

Im folgenden wird die erfindungsgemässe Impulsspannungsgeneratorschaltung unter Bezugnahme auf die beigefügten Zeichnungen und anhand von fünf Ausführungsbeispielen detaillierter beschrieben. Es zeigen:
- Fig. 1 -: ein Prinzipschema einer ersten Schaltung mit einer aufladbaren Stufe und einem Schaltungszusatz mit Entladewiderstand;
- Fig. 2 -: ein Prinzipschema einer zweiten Schaltung mit zwei aufladbaren Stufen und einem Schaltungszusatz mit Entladewiderstand;

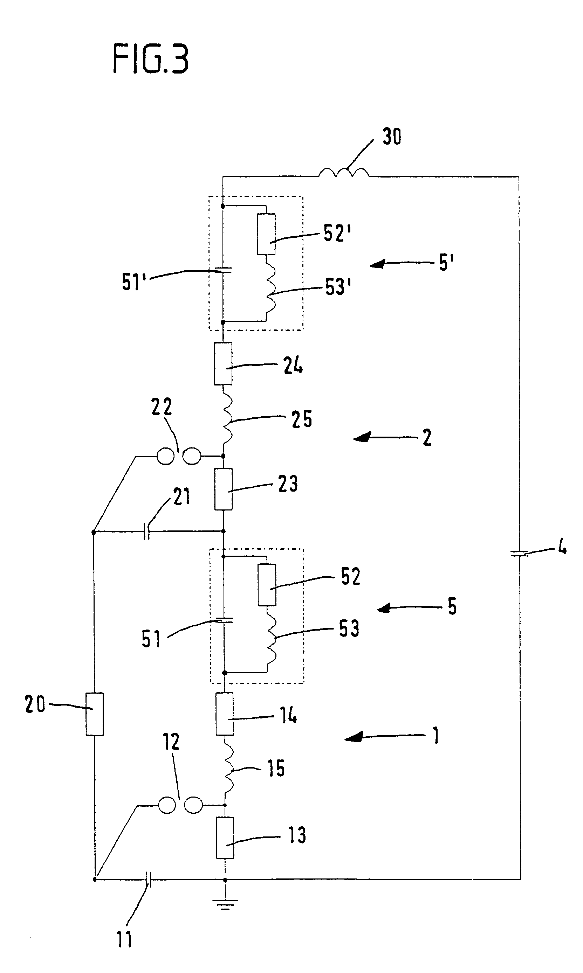

- Fig. 3 -: ein Prinzipschema einer dritten Schaltung mit zwei aufladbaren Stufen, wobei jeder Stufe ein Schaltungszusatz mit Entladewiderstand zugeordnet ist;

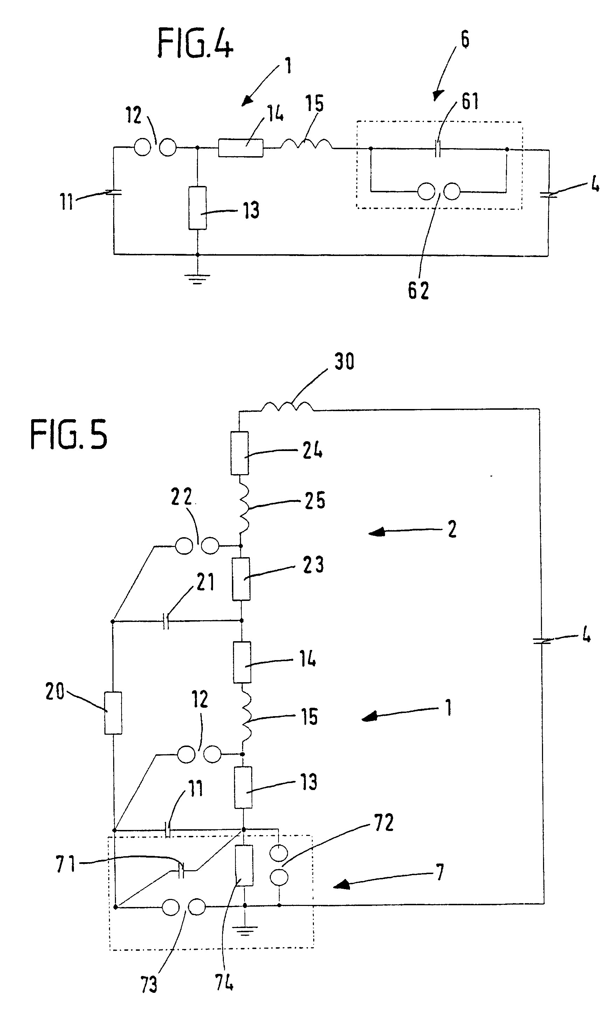

- Fig. 4 -: ein Prinzipschema einer vierten Schaltung mit einer aufladbaren Stufe und einem Schaltungszusatz mit Entladefunkenstrecke;
- Fig. 5 -: ein Prinzipschema einer fünften Schaltung mit zwei aufladbaren Stufen und einem vorgeschalteten Schaltungszusatz mit Entladefunkenstrecke;
- Fig. 6 -: eine Frontansicht eines erfindungsgemässen Impulsspannungsgenerators mit Schaltungszusatz in Form eines externen Zusatzes und Impulsspannungsteilers;
- Fig. 7 -: eine Draufsicht auf den Impulsspannungsgenerator mit Schaltungszusatz und Impulsspannungsteiler von Fig. 6 und
- Fig. 8 -: einen Horizontalschnitt durch einen erfindungsgemässen Impulsspannungsgenerator mit den einzelnen aufladbaren Stufen zugeordneten Schaltungszusätzen.

### Figur 1

Die dargestellte Prüfschaltung umfasst eine Impulsspannungsgeneratorschaltung mit einer einzigen aufladbaren Stufe 1 und einem Schaltungszusatz 5 sowie eine Belastungskapazität 4. Die aufladbare Stufe 1 weist in Serie geschaltet eine Stosskapazität 11 und eine Schaltfunkenstrecke 12, zu der Stosskapazität 11 und der Schaltfunkenstrecke 12 parallelgeschaltet einen Parallelwiderstand 13 sowie zu der Stosskapazität 11, der Schaltfunkenstrecke 12 und dem Parallelwiderstand 13 in Serie geschaltet einen Seriewiderstand 14 auf.

Aufgrund der räumlichen Ausdehnung der Prüfanordnung ergibt sich eine unvermeidliche Eigeninduktivität 3 der Prüfschaltung, die zusammen mit der Belastungskapazität 4 einen Schwingkreis bildet, der durch den Seriewiderstand 14 gedämpft wird.

Die Belastungskapazität 4 setzt sich zusammen aus der Kapazität des Prüflings, der Kapazität eines kapazitiven Impulsspannungsteilers, der die beim Entladen der Stufe erzeugte Blitzimpulsspannung auf von Mess- und Aufzeichnungsgeräten verarbeitbare Werte reduziert, und auftretenden Streukapazitäten.

Der Schaltungszusatz 5 ist in Serie geschaltet zwischen der aufladbaren Stufe 1 und der Belastungskapazität 4 angeordnet und umfasst eine Kompensationskapazität 51 und dazu parallelgeschaltet einen Entladewiderstand 52, der eine Entladewiderstandsinduktivität 53 mit sich bringt.

Zur Erzeugung von Blitzimpulsspannung wird die Stosskapazität 11 mittels einer nicht dargestellten Ladeeinheit aufgeladen und dann durch Zünden der Schaltfunkenstrecke 12 entladen. Auf diese Weise wird ein Spannungsimpuls mit einem zunächst schnell ansteigenden (Stirnanstieg) und dann langsam abfallenden (Rücken) Spannungsverlauf erzeugt, wobei während des Stirnanstiegs die Kompensationskapazität und die Belastungskapazität 4 aufgeladen werden. Das Abfallen, d.h. der Rücken des Spannungsimpulses, entsteht durch die gemeinsame Entladung der aufladbaren Stufe 1, des Schaltungszusatzes 5 und der Belastungskapazität 4 über den Parallelwiderstand 13.

Um die Normblitzimpulsspannung 1,2/50 gemäss IEC 60-1 (1989) zu erzeugen, muss der Seriewiderstand 14 zur Erreichung einer ausreichend kleinen Stirnanstiegszeit bei grossen Belastungskapazitäten 4 so klein gewählt werden, dass die erzeugte Blitzimpulsspannung gedämpft schwingt, wobei ein Überschwingen von maximal 5% gegenüber dem nicht oszillierenden Spannungsverlauf zulässig ist, was die maximal zulässige Belastungskapazität 4 begrenzt.

Die Verringerung des Überschwingens der Impulsstirnen der erzeugten Blitzimpulsspannung bei der Belastungskapazität 4 wird vom Schaltungszusatz 5 im wesentlichen dadurch bewirkt, dass während des Stirnanstiegs eine Spannungsteilung zwischen der Kompensationskapazität 51 und der Belastungskapazität 4 besteht. Danach klingt das Überschwingen ab und die Kompensationskapazität 51 entlädt sich über den Entladewiderstand 52. Nach Entladung der Kompensationskapazität 51 ist die Spannungsteilung aufgehoben und die Spannung an der Belastungskapazität 4 ist dann die Differenz zwischen der oszillierenden Spannung über der Serieschaltung von Kompensationskapazität 51 und Belastungskapazität 4 und der Impulsspannung an der Kompensationskapazität 51.

Durch geeignete Wahl der Kompensationskapazität 51, des Entladewiderstands 52 und der Entladewiderstandsinduktivität 53 kann mit Hilfe des Schaltungszusatzes 5 die Grenzbelastungskapazität der vorliegenden Impulsspannungsgeneratorschaltung etwa verdoppelt werden.

Für die gesamte weitere Beschreibung gilt folgende Festlegung. Sind in einer Figur zum Zweck zeichnerischer Eindeutigkeit Bezugsziffern enthalten, aber im unmittelbar zugehörigen Beschreibungstext nicht erläutert, so wird auf deren Erwähnung in vorangehenden Figurenbeschreibungen Bezug genommen.

### Figur 2

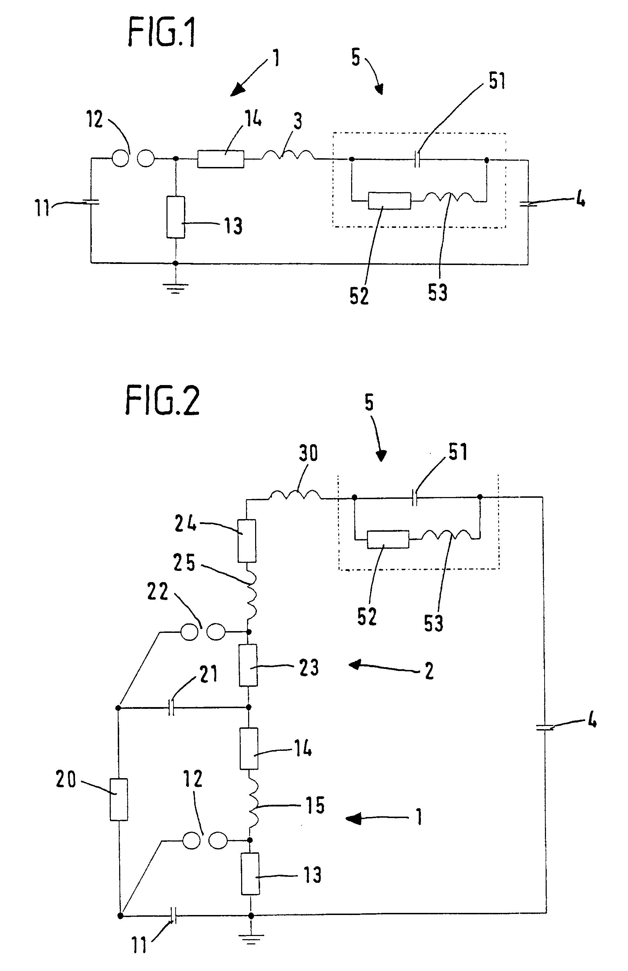

Die Impulsspannungsgeneratorschaltung weist bei diesem zweiten Ausführungsbeispiel zwei aufladbare Stufen 1, 2 auf, die im wesentlichen entsprechend der in Fig. 1 dargestellten und in diesem Zusammenhang erläuterten aufladbaren Stufe aufgebaut sind, wobei bei der zweiten aufladbaren Stufe 2 die Stosskapazität mit 21, die Schaltfunkenstrecke mit 22, der Parallelwiderstand mit 23 und der Seriewiderstand mit 24 bezeichnet sind.

Anstelle der Eigeninduktivität der ganzen Prüfschaltung sind hier die Eigeninduktivitäten 15, 25 der beiden aufladbaren Stufen 1, 2 und die Eigeninduktivität 30 der äusseren Schleife, bestehend aus Schaltungszusatz 5, Prüfling, Impulsspannungsteiler und Verbindungsleitungen, angegeben.

Die beiden aufladbaren Stufen 1, 2 sind einerseits über den Seriewiderstand 14 und anderseits über einen hochohmigen Ladewiderstand 20 miteinander verbunden. Beim Aufladen werden sie parallelgeschaltet mittels einer nicht dargestellten Ladeeinheit direkt bzw. über den Ladewiderstand 20 aufgeladen. Nach Zünden der Schaltfunkenstrecken 12 und 22 werden sie in Serie geschaltet entladen, wobei die Verbindung zwischen den beiden Stufen 1, 2 über den im Vergleich zum Ladewiderstand 20 relativ niederohmigen Seriewiderstand 14 erfolgt.

Die Verringerung des Überschwingens der Impulsstirnen der erzeugten Blitzimpulsspannung bei der Belastungskapazität 4 durch den Schaltungszusatz 5 erfolgt analog zu dem im Zusammenhang mit Fig. 1 erläuterten ersten Ausführungsbeispiel.

### Figur 3

Bei diesem dritten Ausführungsbeispiel ist die Impulsspannungsgeneratorschaltung ähnlich aufgebaut wie beim vorherigen Ausführungsbeispiel. Der einzige Unterschied besteht darin, dass anstelle eines einzigen, ausserhalb des eigentlichen Impulsspannungsgenerators angeordneten Schaltungszusatzes zwei entsprechend aufgebaute Schaltungszusätze 5, 5' verwendet werden, die jeweils direkt einer der aufladbaren Stufen 1, 2 in Serie geschaltet nachgeordnet sind, wobei beim Schaltungszusatz 5' die Kompensationskapazität mit 51', der Entladewiderstand mit 52' und die Entladewiderstandsinduktivität mit 53' bezeichnet sind.

Die Verringerung des Überschwingens der Impulsstirnen der erzeugten Blitzimpulsspannung an der Belastungskapazität 4 durch die Schaltungszusätze 5, 5' erfolgt analog zu den vorherigen Ausführungsbeispielen.

### Figur 4

Das dargestellte, vierte Ausführungsbeispiel entspricht bis auf den Schaltungszusatz 6 dem ersten Ausführungsbeispiel.

Der Schaltungszusatz 6 weist hier eine Kompensationskapazität 61, die im allgemeinen grösser ist als die in Fig. 1 dargestellte Kompensationskapazität 51, und dazu parallelgeschaltet eine Entladefunkenstrecke 62, die zeitlich verzögert zur Zündung der Schaltfunkenstrecke 12 triggerbar ist, auf.

Die Funktionsweise des Schaltungszusatzes 6 ist ähnlich wie beim ersten Ausführungsbeispiel. Während des Stirnanstiegs eines erzeugten Spannungsimpulses wird die Serieschaltung Kompensationskapazität 61 - Belastungskapazität 4 aufgeladen. Es besteht eine Spannungsteilung zwischen der Kompensationskapazität 61 und der Belastungskapazität 4, die das Überschwingen der Impulsstirn bei der Belastungskapazität 4 verringert. Etwa bei Erreichen des Scheitels wird dann die Entladefunkenstrecke 62 getriggert, wodurch die Kompensationskapazität 61 kurzgeschlossen und die Spannungsteilung aufgehoben wird.

### Figur 5

Das dargestellte, fünfte Ausführungsbeispiel entspricht bis auf den Schaltungszusatz dem zweiten Ausführungsbeispiel.

Anstelle eines zwischen der zweiten aufladbaren Stufe 2 und der Belastungskapazität 4 angeordneten Schaltungszusatzes ist hier ein Schaltungszusatz 7 der ersten aufladbaren Stufe 1 vorgeschaltet. Der Schaltungszusatz 7 weist in Serie geschaltet eine Kompensationsfunkenstrecke 73 und eine Kompensationskapazität 71 und zu der Kompensationsfunkenstrecke 73 und der Kompensationskapazität 71 parallelgeschaltet einen Ladewiderstand 74 sowie eine Entladefunkenstrecke 72 auf.

Während des Aufladens der beiden aufladbaren Stufen 1, 2 wird die Kompensationskapazität 71 über den vorteilhafterweise hochohmigen Ladewiderstand 74 mitaufgeladen. Beim Entladen der aufladbaren Stufen 1, 2 wird die Kompensationskapazität 71 in einer ersten Phase durch Zünden, d.h. Triggern, der Kompensationsfunkenstrecke 73 so geschaltet, dass die Spannung der aufladbaren Stufen 1, 2 um die Spannung der Kompensationskapazität 71 reduziert wird. In einer zweiten Phase, die etwa bei Erreichen des Scheitels des erzeugten Spannungsimpulses beginnt, wird die Kompensationskapazität 71 durch Zünden der Entladefunkenstrecke 72 kurzgeschlossen, wodurch die Spannungsreduzierung aufgehoben wird.

### Figuren 6 und 7

Der dargestellte erfindungsgemässe Impulsspannungsgenerator 100 weist einen Schaltungszusatz in Form eines externen Zusatzes 50 auf, der auch nachträglich an bereits vorhandenen Impulsspannungsgeneratoren angebracht werden kann. Am einen Ende des externen Zusatzes 50 ist ein herkömmlicher, hier nicht näher beschriebener, kapazitiver Impulsspannungsteiler 200 zur Reduzierung der erzeugten Blitzimpulsspannung auf von nicht dargestellten Mess- und Aufzeichnungsgeräten verarbeitbare Werte angeschlossen.

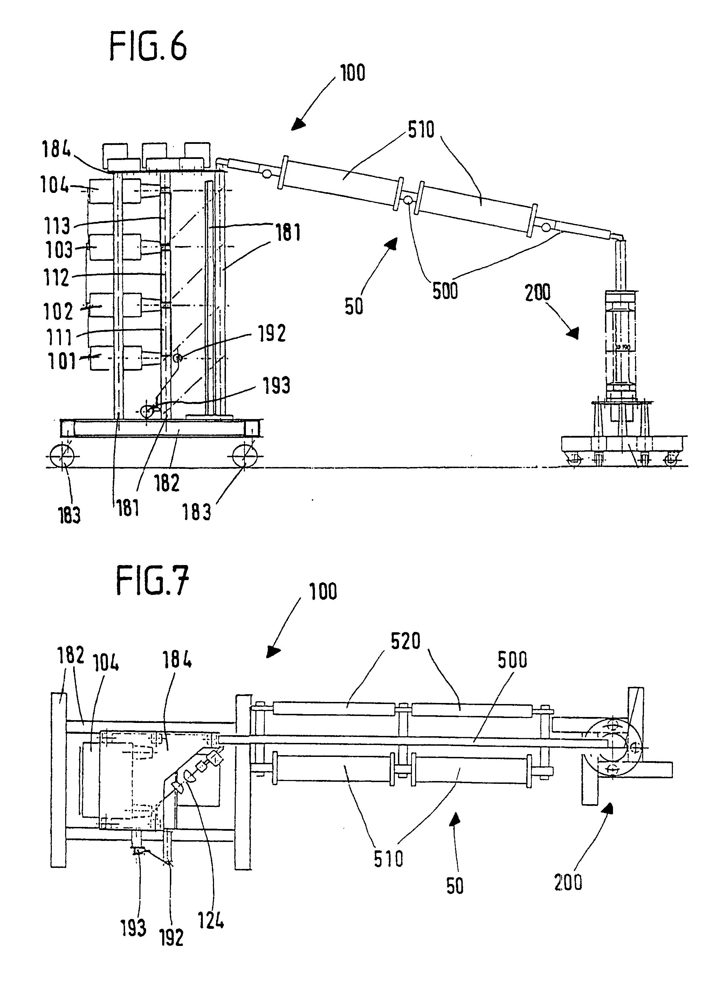

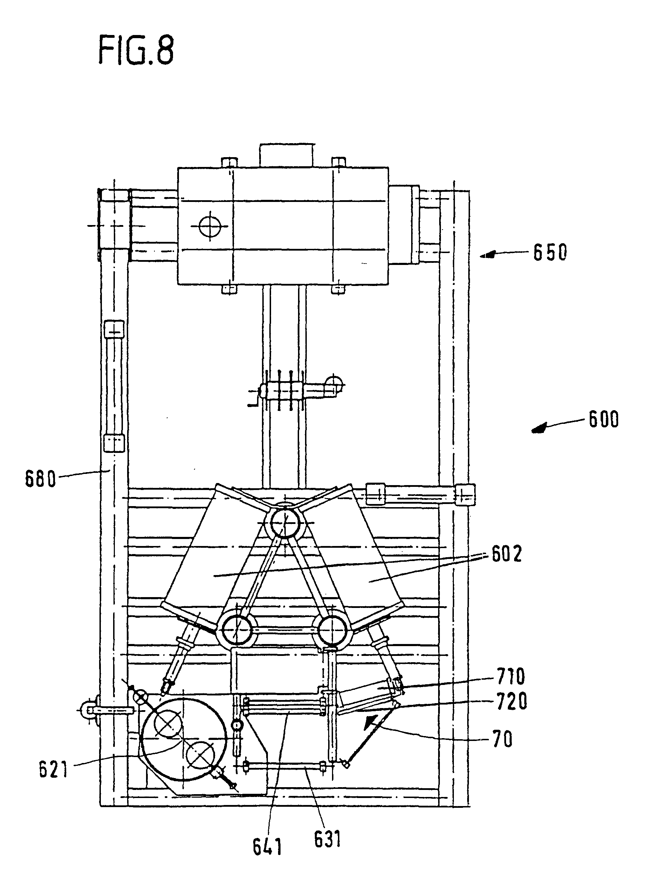

Der Impulsspannungsgenerator 100 ist in der Schaltung gemäss dem zweiten Ausführungsbeispiel aufgebaut, aber mit vier anstatt nur zwei aufladbaren Stufen mit Stosskapazitäten 101, 102, 103, 104 und Ladewiderständen 111, 112, 113. Die Lage der Schaltfunkenstrecken, Parallelwiderstände und Seriewiderstände ist in Fig. 6 strichpunktiert angedeutet. In Fig. 7 ist die Schaltfunkenstrecke 124 der vierten Stufe sichtbar. Die Aufladung der Stosskapazitäten 101, 102, 103, 104 erfolgt mit einer nicht dargestellten Ladeeinheit über einen Ladeeinheitanschluss 192. Ein Ladeschalter 193 dient zur Entladung der Stosskapazitäten 101, 102, 103, 104 beim Ausschalten des Impulsspannungsgenerators 100 oder Unterbruch einer nicht dargestellten Sicherheitsschaltung. Die einzelnen Schaltungselemente sind an senkrechten Tragprofilen 181 befestigt, die auf einem mit Rollen 183 versehenen Grundrahmen 182 angebracht sind. Oberhalb der obersten Stufe ist eine Abdeckplatte 184 angeordnet.

Der externe Zusatz 50 weist einen zweiteiligen Kompensationskondensator 510, d.h. Kompensationskapazität, und dazu parallelgeschaltet einen zweiteiligen Entladewiderstand 520 auf, die an einem Traggestell 500 befestigt sind. Ein Entladewiderstandsteil ist beispielsweise als ein auf ein zylindrisches Isolierrohr in Kreuzwicklung gewickelter Drahtwiderstand ausgebildet. Ein modularer Aufbau des Kompensationskondensators 510 und des Entladewiderstands 520 ermöglicht eine Anpassung an verschiedene Impulsspannungsgeneratoren einer Typenreihe. Das Traggestell 500 ist zwischen einem der senkrechten Tragprofile 181 des Impulsspannungsgenerators 100 und dem Impulsspannungsteiler 200 aufgehängt, könnte aber beispielsweise auch auf separaten Isolierstützen gelagert sein.

Im folgenden ist für den obigen Impulsspannungsgenerator 100 ein konkretes Zahlenbeispiel angegeben. Der Impulsspannungsgenerator 100 weist dabei eine Summenladespannung von 400 kV und eine Ladeenergie von 20 kJ auf und ist mit Seriewiderständen von 12 Ω je aufladbarer Stufe ausgerüstet. Die Anpassung an die Prüflingskapazität erfolgt mittels austauschbarer externer Seriewiderstände. Die Induktivität beträgt etwa 2,5 µH pro Stufe, während für die externe Verbindung zum Prüfling eine Induktivität von 6 µH angenommen wird. Bei einer totalen Prüfschaltungsinduktivität von 16 µH könnte ohne externen Zusatz 50 eine maximale Belastungskapazität (Kapazitäten des Prüflings und des Impulsspannungsteilers 200 und Streukapazitäten) von 15,5 nF normgerecht geprüft werden, wobei dann die externen Seriewiderstände ausgeschaltet sind.

Die beiden Teile des Kompensationskondensators 510 des externen Zusatzes 50 haben je eine Kapazität von 32 nF und sind für eine Impulsspannung von mindestens 150 kV ausgelegt, was für den Kompensationskondensator 510 eine Kapazität von 16 nF ergibt. Der Entladewiderstand 520 beträgt insgesamt 24 Ω und die sich durch die Wicklung ergebende Entladewiderstandsinduktivität 3 µH. Ferner gehören zum externen Zusatz 50 innere Seriewiderstände von 0,5 Ω je aufladbarer Stufe des Impulsspannungsgenerators, also insgesamt 2 Ω, und wahlweise zwei externe Seriewiderstände von 5 Ω und 10 Ω. Mit den innern Seriewiderständen und dem externen Seriewiderstand von 10 Ω kann der Impulsspannungsgenerator unter Erfüllung der Norm IEC 60-1 bis zu einer Belastungskapazität von 25 nF, mit den inneren Seriewiderständen und dem externen Seriewiderstand von 5 Ω bis zu einer Belastungskapazität von 31 nF und nur mit den inneren Seriewiderständen bis zu einer Belastungskapazität von 36 nF belastet werden.

### Figur 8

Der erfindungsgemässe Impulsspannungsgenerator 600 ist in der Schaltung gemäss dem dritten Ausführungsbeispiel aufgebaut, aber vorteilhafterweise mit mehr als zwei aufladbaren Stufen. Die dargestellte Stosskapazität 602 einer Stufe ist zweiteilig ausgebildet und mit einem Schaltungszusatz 70 der darunterliegenden Stufe verbunden. Der Schaltungszusatz 70 weist einen Kompensationskondensator 710, d.h. Kompensationskapazität, und dazu parallelgeschaltet einen Entladewiderstand 720 auf, der beispielsweise als ein auf einen flachen Isolierkörper in Kreuzwicklung gewickelter Drahtwiderstand ausgebildet ist. Über Seriewiderstände 641 ist der Schaltungszusatz 70 mit einer Schaltfunkenstrecke 621 verbunden. Mit 631 ist der der Schaltfunkenstrecke 621 zugeordnete Parallelwiderstand bezeichnet, während der Ladewiderstand zum Aufladen der Stosskapazität 602 nicht dargestellt ist. Für die Erdung des Impulsspannungsgenerators ist eine motorgetriebene Erdungseinrichtung 650 vorgesehen. Die einzelnen Schaltungselemente sind an einem Traggestell 680 befestigt, das vorzugsweise mit Rollen versehen ist.

Im folgenden ist für den obigen Impulsspannungsgenerator 600 ein konkretes Zahlenbeispiel angegeben. Der Impulsspannungsgenerator 600 weist dabei zehn aufladbare Stufen mit einer Summenladespannung von 2000 kV und eine Ladeenergie von 200 kJ auf und ist mit Seriewiderständen 641 von 46 Ω, 30 Ω und 22 Ω je aufladbarer Stufe ausgerüstet. Die Anpassung an die Prüflingskapazität erfolgt durch geeignete Kombination der Seriewiderstände in jeder Stufe, wobei der kleinste realisierbare Seriewiderstand je Stufe bei Parallelschaltung der drei Seriewiderstände 9,95 Ω beträgt. Jede Stufe weist dann eine Induktivität von etwa 3,5 µH auf, während für die externe Verbindung zum Prüfling eine Induktivität von 18 µH angenommen wird. Bei einer totalen Prüfschaltungsinduktivität von 53 µH könnte ohne Schaltungszusatz 70 eine maximale Belastungskapazität (Kapazitäten des Prüflings und des Impulsspannungsteilers und Streukapazitäten) von 3,85 nF normgerecht geprüft werden, wobei dann 3 Stufen mit einer Parallelschaltung der Seriewiderstände 46 Ω und 30 Ω und sieben Stufen allein mit dem Seriewiderstand 22 Ω ausgerüstet sind, so dass der totale Seriewiderstand 159 Ω beträgt.

Der Kompensationskondensator 710 des Schaltungszusatzes 70 in jeder Stufe hat eine Kapazität von 50 nF und ist für eine Impulsspannung von 180 kV ausgelegt. Der Entladewiderstand 720 beträgt in jeder Stufe 8 Ω und die sich durch die Wicklung ergebende Entladewiderstandsinduktivität 1,5 µH. Zum Schaltungszusatz 70 gehören ferner Seriewiderstände, mit denen sich ein totaler Seriewiderstand von 10 Ω, 20 Ω, 30 Ω, 55 Ω oder 70 Q realisieren lässt. Damit kann der Impulsspannungsgenerator unter Erfüllung der Norm IEC 60-1 bis zu einer Belastungskapazität von 10,5 nF belastet werden.

Zu den vorbeschriebenen Impulsspannungsgeneratoren sind weitere konstruktive Variationen realisierbar. Insbesondere kann die Anzahl der aufladbaren Stufen problemlos variiert werden.

## Patentansprüche

1. Impulsspannungsgeneratorschaltung zum Erzeugen von Blitzimpulsspannung zum Prüfen der Kapazität eines Prüflings, mit einer einzigen oder mehreren aufladbaren Stufen (1, 2), wobei die bzw. jede Stufe (1, 2) in Serie geschaltet eine Stosskapazität (11, 21) und ein Schaltorgan, zu der Stosskapazität (11, 21) und dem Schaltorgan parallelgeschaltet einen Parallelwiderstand (13, 23) sowie zu der Stosskapazität (11, 21), dem Schaltorgan und dem Parallelwiderstand (13, 23) in Serie geschaltet einen Seriewiderstand (14, 24) aufweist, gegebenenfalls zwei Stufen (1, 2) so miteinander verbunden sind, dass sie parallelgeschaltet aufladbar und in Serie geschaltet entladbar sind, und an die einzige bzw. die letzte Stufe (1, 2) eine die Prüflingskapazität mitumfassende Belastungskapazität (4) anschliessbar ist, sowie mit mindestens einem Schaltungszusatz (5, 5', 6, 7) zur Verringerung des Überschwingens der Impulsstirnen der Blitzimpulsspannung an der Belastungskapazität (4), der eine Kompensationskapazität (51, 51', 61, 71) umfasst, **dadurch gekennzeichnet, dass** der Schaltungszusatz (5, 5', 6, 7) zu der Kompensationskapazität (51, 51', 61, 71) parallelgeschaltet zumindest einen Entladewiderstand (52, 52') oder eine Entladefunkenstrecke (62, 72) aufweist.

2. Impulsspannungsgeneratorschaltung nach Anspruch 1, **dadurch gekennzeichnet, dass** das bzw. die Schaltorgane eine Schaltfunkenstrecke (12) ist bzw. Schaltfunkenstrecken (12, 22) sind.

3. Impulsspannungsgeneratorschaltung nach Anspruch 1 oder 2, **dadurch gekennzeichnet, dass** der Schaltungszusatz (5, 6) bzw. die Schaltungszusätze (5, 5') jeweils dem Seriewiderstand (14, 24) einer aufladbaren Stufe (1, 2) in Serie nachgeschaltet ist bzw. sind.

4. Impulsspannungsgeneratorschaltung nach Anspruch 3 mit mehreren aufladbaren Stufen (1, 2), **dadurch gekennzeichnet, dass** der Schaltungszusatz (5, 6) bzw. einer der Schaltungszusätze (5, 5') dem Seriewiderstand (14, 24) der letzten aufladbaren Stufe (1, 2) in Serie nachgeschaltet ist.

5. Impulsspannungsgeneratorschaltung nach Anspruch 4, **dadurch gekennzeichnet, dass** dem Seriewiderstand (14, 24) jeder aufladbaren Stufe (1, 2) einer der Schaltungszusätze (5, 5', 6) in Serie nachgeschaltet ist.

6. Impulsspannungsgeneratorschaltung nach Anspruch 1 oder 2, **dadurch gekennzeichnet, dass** der bzw. mindestens einer der aufladbaren Stufen (1) ein Schaltungszusatz (7) vorgeschaltet ist.

7. Impulsspannungsgeneratorschaltung nach Anspruch 6, **dadurch gekennzeichnet, dass** der Schaltungszusatz (7) in Serie geschaltet eine Kompensationsfunkenstrecke (73) und eine Kompensationskapazität (71) und zu der Kompensationsfunkenstrecke (73) und der Kompensationskapazität (71) parallelgeschaltet sowohl einen Ladewiderstand (74) als auch eine Entladefunkenstrecke (72) aufweist, derart, dass die Kompensationskapazität (71) während des Aufladens der nachgeschalteten aufladbaren Stufe (1) mitaufgeladen wird und beim Entladen der aufladbaren Stufe (1) in einer ersten Phase durch Zünden der Kompensationsfunkenstrecke (73) so geschaltet ist, dass die Spannung der aufladbaren Stufe (1) um die Spannung der Kompensationskapazität (71) reduziert wird, und in einer zweiten Phase durch Zünden der Entladefunkenstrecke (72) kurzgeschlossen ist.

8. Impulsspannungsgeneratorschaltung nach einem der Ansprüche 1 bis 7 mit mindestens einem Schaltungszusatz (6, 7) mit einer Entladefunkenstrecke (62, 72), **dadurch gekennzeichnet, dass** die Entladefunkenstrecke (62, 72) zeitlich verzögert zur Auslösung des Schaltorgans, insbesondere Zündung der Schaltfunkenstrecke (12), der zugehörigen aufladbaren Stufe (1) triggerbar ist.

9. Schaltungszusatz für eine Impulsspannungsgeneratorschaltung, die zum Erzeugen von Blitzimpulsspannung zum Prüfen der Kapazität eines Prüflings dient und eine einzige oder mehrere aufladbare Stufen (1, 2) aufweist, wobei die bzw. jede Stufe (1, 2) in Serie geschaltet eine Stosskapazität (11, 21) und ein Schaltorgan, zu der Stosskapazität (11, 21) und dem Schaltorgan parallelgeschaltet einen Parallelwiderstand (13, 23) sowie zu der Stosskapazität (11, 21), dem Schaltorgan und dem Parallelwiderstand (13, 23) in Serie geschaltet einen Seriewiderstand (14, 24) aufweist, gegebenenfalls zwei Stufen (1, 2) so miteinander verbunden sind, dass sie parallelgeschaltet aufladbar und in Serie geschaltet entladbar sind, und an die einzige bzw. die letzte Stufe (1, 2) eine die Prüflingskapazität mitumfassende Belastungskapazität (4) anschliessbar ist, und wobei die Impulsspannungsgeneratorschaltung mindestens einen Schaltungszusatz (5, 5', 6, 7) zur Verringerung des Überschwingens der Impulsstirnen der Blitzimpulsspannung an der Belastungskapazität (4) aufweist, der eine Kompensationskapazität (51, 51', 61, 71) verwendet, **dadurch gekennzeichnet, dass** der Schaltungszusatz (5,5', 6,7) parallelgeschaltet zu der Kompensationskapazität (51, 51', 61, 71) zumindest einen Entladewiderstand (52, 52') oder eine Entladefunkenstrecke (62, 72) aufweist.

10. Schaltungszusatz nach Anspruch 9, **dadurch gekennzeichnet, dass** er in Serie geschaltet eine Kompensationskapazität (71) und eine Kompensationsfunkenstrecke (73) und zu der Kompensationsfunkenstrecke (73) und der Kompensationskapazität (71) parallelgeschaltet sowohl einen Ladewiderstand (74) als auch eine Entladefunkenstrecke (72) aufweist.

## Claims

1. Voltage pulse generator circuit for generating lightning pulse voltage for testing the capacity of a sample, with a single or several rechargeable stages (1,2), wherein the or each stage (1, 2) comprises a surge capacitor (11, 21) connected in series and a switching device, a parallel resistor (13, 23) connected parallel to the surge capacitor (11, 21) and the switching device, as well as a series resistor (14, 24) connected in series to the surge capacitor (11, 21), the switching device and the parallel resistor (13, 23), if applicable two stages (1, 2) are connected in such a manner that they can be charged in parallel and discharged in series, and a load capacitor (4) including the sample capacitance can be connected to the single or last stage (1, 2), as well as with at least one additional circuit (5, 5', 6, 7) comprising a compensation capacitor (51, 51', 61, 71) for reducing the overshoot of the rising edge of the lightning pulse voltage over the load capacitor (4), **characterised in that** the additional circuit (5, 5', 6, 7) comprises at least one discharge resistor (52, 52') or a discharge spark gap (62, 72) connected parallel to the compensation capacitor (51, 51', 61, 71).

2. Voltage pulse generator circuit of claim 1 **characterised in that** the switching device or devices is or are a switch spark gap (12) or switch spark gaps (12, 22), respectively.

3. Voltage pulse generator circuit of claim 1 or 2 **characterised in that** the additional circuit (5, 6) or the additional circuits (5, 5') each is or are connected in series downstream of the series resistor (14, 24) of a rechargeable stage (1, 2).

4. Voltage pulse generator circuit of claim 3 with several rechargeable stages (1, 2) **characterised in that** the additional circuit (5, 6) or one of the additional circuits (5, 5') is connected downstream of the series capacitor (14, 24) of the last rechargeable stage (1, 2).

5. Voltage pulse generator circuit of claim 4 **characterised in that** one of the additional circuits (5, 5', 6) is connected in series downstream of the series resistor (14, 24) of each rechargeable stage (1, 2).

6. Voltage pulse generator circuit of claim 1 or 2 **characterised in that** an additional circuit (7) is connected upstream of the rechargeable stage or at least one of the rechargeable stages (1).

7. Voltage pulse generator circuit of claim 6 **characterised in that** the additional circuit (7) comprises connected in series a compensation spark gap (73) and a compensation capacitor (71) and in parallel to the compensation spark gap (73) and the compensation capacitor (71) a charge resistor (74) as well as a discharge spark gap (72) such that the compensation capacitor (71) is also charged during charging of the following rechargeable stage (1) and, in a first phase during discharge of the chargeable stage (1), is, by sparking the compensation spark gap (73), connected such that the voltage of the chargeable stage (1) is reduced by the voltage of the compensation capacitor (71) and, in a second phase, is shorted by sparking the discharge spark gap (72).

8. Voltage pulse generator circuit of one of the claims 1 to 7 with at least one additional circuit (6, 7) with a discharge spark gap (62, 72) **characterised in that** the discharge spark gap (62, 72) can be triggered in time delayed manner for triggering the switching device, in particular for sparking the switching spark gap (12), of the corresponding rechargeable stage (1).

9. Additional circuit for a voltage pulse generator circuit, which voltage pulse generator circuit serves for testing the capacitance of a sample and comprises a single or several stages (1, 2), wherein the or each stage (1, 2) comprises a surge capacitor (11, 21) connected in series and a switching device, a parallel resistor (13, 23) connected parallel to the surge capacitor (11, 21) and the switching device, as well as a series resistor (14, 24) connected in series to the surge capacitor (11, 21), the switching device and the parallel resistor (13, 23), if applicable two stages (1 2) are connected in such a manner that they can be charged in parallel and discharged in series, and a load capacitor (4) including the sample capacitance can be connected to the single or last stage (1, 2), and wherein the lightning pulse generator circuit comprises at least one additional circuit (5, 5', 6, 7) having a compensation capacitor (51, 51', 61, 71) for reducing the overshoot of the rising edge of the lightning pulse voltage over the load capacitor (4), **characterised in that** the additional circuit (5, 5', 6, 7) comprises at least one discharge resistor (52, 52') or a discharge spark gap (62, 72) connected parallel to the compensation capacitor (51, 51', 61, 71).

10. Additional circuit of claim 9 **characterised in that** it comprises, in series, a compensation capacitor (71) and a compensation discharge gap (73) and in parallel to the compensation discharge gap (73) and the compensation capacitor (71) a charge capacitor (74) as well as a discharge spark gap (72).

## Revendications

1. circuit générateur de tension de choc pour produire une tension à impulsions éclairs afin de tester la capacité d'un échantillon, avec un seul ou plusieurs étages (1, 2) pouvant être chargés, le ou chaque étage (1, 2) comportant une capacité de choc (11, 21) et un élément de commutation branchés en série, une résistance parallèle (13, 23) branchée en parallèle avec la capacité de choc (11, 21) et avec l'élément de commutation ainsi qu'une résistance série (14, 24) branchée en série avec la capacité de choc (11, 21), avec l'élément de commutation et avec la résistance parallèle (13, 23), le cas échéant deux étages (1, 2) étant reliés ensemble de telle sorte qu'ils peuvent être chargés branchés en parallèle et déchargés branchés en série, et une capacité de charge (4) qui comprend la capacité d'échantillon pouvant être raccordée à l'unique ou au dernier étage (1, 2), ainsi qu'avec au moins un supplément de circuit (5, 5', 6, 7) qui est destiné à réduire la suroscillation des fronts d'impulsions de la tension à impulsions éclairs sur la capacité de charge (4) et qui comprend une capacité de compensation. (51, 51', 61, 71), **caractérisé en ce que** le supplément de circuit (5, 5', 6, 7) comporte au moins une résistance de décharge (52, 52') ou un éclateur (62, 72) branchés en parallèle avec la capacité de compensation (51, 51', 61, 71).

2. Circuit générateur de tension de choc selon la revendication 1, **caractérisé en ce que** le ou les éléments de commutation sont un éclateur (12) ou des éclateurs (12, 22).

3. Circuit générateur de tension de choc selon la revendication 1 ou 2, **caractérisé en ce que** le supplément de circuit (5, 6) ou les suppléments de circuit (5, 5') sont branchés en série à chaque fois en aval de la résistance série (14, 24) d'un étage (1, 2) pouvant être chargé.

4. Circuit générateur de tension de choc selon la revendication 3, avec plusieurs étages (1, 2) pouvant être chargés, **caractérisé en ce que** le supplément de circuit (5, 6) ou l'un des suppléments de circuit (5, 5') est branché en série en aval de la résistance série (14, 24) du dernier étage (1, 2) pouvant être chargé.

5. Circuit générateur de tension de choc selon la revendication 4, **caractérisé en ce que** l'un des suppléments de circuit (5, 5', 6) est branché en série en aval de la résistance série (14, 24) de chaque étage (1, 2) pouvant être chargé.

6. Circuit générateur de tension de choc selon la revendication 1 ou 2, **caractérisé en ce qu'**un supplément de circuit (7) est branché en amont du ou au moins de l'un des étages (1) pouvant être chargés.

7. Circuit générateur de tension de choc selon la revendication 6, **caractérisé en ce que** le supplément de circuit (7) comporte un éclateur de compensation (73) et une capacité de compensation (71) branchée en série et une résistance de charge (74) ainsi qu'un éclateur (72) branchés en parallèle avec l'éclateur de compensation (73) et avec la capacité de compensation (71) de telle sorte que la capacité de compensation (71) est chargée en même temps pendant le chargement de l'étage (1) pouvant être chargé et branché en aval et est branchée lors du déchargement de l'étage (1) pouvant être chargé dans une première phase par l'allumage de l'éclateur de compensation (73), de telle sorte que la tension de l'étage (1) pouvant être chargé est réduite de la tension de la capacité de compensation (71), et est coure-circuitée dans une deuxième phase par l'allumage de l'éclateur (72).

8. Circuit générateur de tension de choc selon l'une des revendications 1 à 7, avec au moins un supplément de circuit (6, 7) avec un éclateur (62, 72), **caractérisé en ce que** l'éclateur (62, 72) peut être déclenché avec un retard pour le déclenchement de l'élément de commutation, notamment pour l'allumage de l'éclateur (12), de l'étage (1) associé pouvant être chargé.

9. Supplément de circuit pour un circuit générateur de tension de choc qui sert à produire une tension à impulsions éclairs afin de tester la capacité d'un échantillon et qui comporte un seul ou plusieurs étages (1, 2) pouvant être chargés, le ou chaque étage (1, 2) comportant une capacité de choc (11, 21) et un élément de commutation branchés en série, une résistance parallèle (13, 23) branchée en parallèle avec la capacité de choc (11, 21) et avec l'élément de commutation ainsi qu'une résistance série (14, 24) branchée en série avec la capacité de choc (11, 21), avec l'élément de commutation et avec la résistance parallèle (13, 23), le cas échéant deux étages (1, 2) étant reliés ensemble de telle sorte qu'ils peuvent être chargés branchés en parallèle et déchargés branchés en série, et une capacité de charge (4) qui comprend la capacité d'échantillon pouvant étire raccordée à l'unique ou au dernier étage (1, 2), et le circuit générateur de tension de choc comportant au moins un supplément de circuit (5, 5', 6, 7) qui est destiné à réduire la suroscillation des fronts d'impulsions de la tension à impulsions éclairs sur la capacité de charge (4) et qui utilise une capacité de compensation (51, 51', 61, 71), **caractérisé en ce que** le supplément de circuit (5, 5', 6, 7) comporte au moins une résistance de décharge (52, 52') ou un éclateur (62, 72) branchés en parallèle avec la capacité de compensation (51, 51', 61, 71).

10. Supplément de circuit selon la revendication 9, **caractérisé en ce qu'**il comporte une capacité de compensation (71) et un éclateur de compensation (73) branchés en série et une résistance de charge (74) ainsi qu'un éclateur (72) branchés en parallèle avec l'éclateur de compensation (73) et la capacité de compensation (71).
